# EUROPEAN PATENT SPECIFICATION

(11) **EP 2 825 684 B1**
(45) Date of publication and mention of the grant of the patent: **18.05.2016**
(21) Application number: 13714217.0
(22) Date of filing: 06.03.2013
(51) Int. Cl.: C23C 16/44, C23C 14/24, C23C 14/26, H01R 4/28, H01R 4/48

(54) **VACUUM DEPOSITION SOURCE HEATING SYSTEM AND VACUUM DEPOSITION SYSTEM**
VAKUUMABSCHEIDUNGSQUELLEN-HEIZUNGSSYTEM UND VAKUUMABSCHEIDUNGSSYSTEM
SYSTÈME DE CHAUFFAGE D'UN SOURCE DE DÉPÔT SOUS VIDE ET SYSTÈME DE DÉPÔT SOUS VIDE

(30) Priority: 15.03.2012 DE 102012102210
(43) Date of publication of application: 21.01.2015
(73) Proprietor: Apollo Precision Beijing Limited, Beijing Economic-Technological Development Area Beijing 100005 (CN)
(72) Inventor: MATHIASSON, Johan, S-75267 Uppsala (SE); KESSINGER, Martin, 04155 Leipzig (DE); KRAUSE, Falk, 07745 Jena (DE); AHLGREN, Timo, S-74963 Örsundsbro (SE); STEINBERG, Stefan, 06242 Braunsbedra (DE)
(74) Representative: adares Patent- und Rechtsanwälte Reininger & Partner
(86) International application number: PCT/EP2013/054481
(87) International publication number: WO 2013/135537

(56) References cited:
- WO-A2-2010/019218
- WO-A2-2011/078488
- DE-A1- 2 827 647
- FR-A1- 2 351 496

## Description

The invention relates to a vacuum deposition source heating system and to a vacuum deposition system having such a heating system.

Vacuum deposition relies on the heating of a source material, which evaporates at a specific evaporation temperature and condenses on a substrate placed in the vacuum together with the source. The source material may be placed in a crucible, which is heated by a filament, or the filament itself may be formed as a receptacle to hold the source material. The filament is usually made of a heat resistant conductive material and connected to a current supply. Other designs for heating a source material may be employed. However, in all cases there is a heating element supplied with electrical current by a power source element, which may be a conductive wire or some other rigid lead.

The problem that arises regularly at a rigid contact between the heating element and the power source element is due to a temperature difference between them. Usually, the power source element is covered by an insulating member close or up to the point of contact to the heating element. However, if the contact itself is colder than the heating element, the evaporated source material may also condense on the contact or the power source element and cause a short circuit. If on the other hand the contact is kept at a high temperature, the contact becomes unreliable due to thermal expansion, which may lead to arching.

One solution to such problems is to protect the power source element by an isolating member up to the contact to the heating element, as mentioned above, and by simultaneously heating the contact itself, where the power source element is exposed. The temperature may be held anywhere from 700 to 1500 degrees centigrade or higher. In addition, in order to avoid any loss of contact due to thermal expansion, the contact between the power source element and the heating element is ensured by a spring, which exerts a pressure on the contact, thus compensating for any temperature expansion effects.

One such design is described in WO 2010/019218 A2. The system described therein comprises a heater, which is supplied with electrical current through a metallic power strap. The power strap is sandwiched between a contact washer and a conductive washer. Altogether the power strap and the two washers are pushed against the heater by a pressure pin. For exerting a reliable contact pressure, the pressure pin is loaded with a flat spring, which is made of pyrolythic boron nitride. In the setup disclosed in WO 2010/019218 A2, the boron nitride spring can only be used as an indirect pressure element for pushing the power strap against the contact of the heater. Because boron nitride itself is not a conductive material, the spring made of pyrolythic boron nitride can itself not be used to conduct current. This leads to less flexibility for the design of the heating system.

It is possible to think of a different design having spring supported contacts between a power line and a heater, having tungsten springs. However, tungsten has the disadvantage of creeping when heated above a certain temperature under pressure. Therefore, under high temperatures, a tungsten spring quickly loses its springiness or elasticity. In this case, the spring can no longer maintain a reliable contact between the power line and the heater.

It is the object of the invention to provide a source heating system for a vacuum deposition source and a vacuum deposition system with a reliable power contact at very high temperatures, while allowing a flexible design thereof.

According to the invention, this object is met by a vacuum deposition source heating system having the features of claim 1, and by a vacuum deposition system having the features of claim 11. Advantageous embodiments of the invention are stated in the subordinate claims.

The invention is based on the idea of making the spring element, which is responsible for an elastic connection between the power supply and the heating element of the vacuum deposition source, from an elastic carbon material. The elastic carbon material is advantageously in the form of an elastic graphite material. The connection member is the entity that may consist of a number of elements and that is responsible for electrically connecting the power supply element with the heating element. The spring element is part of the connection member and responsible for allowing the mechanical connection of the connection member with the power supply element to be elastic. A spring element that is made out of carbon material, such as carbon fiber, keeps the pressure of the electrical contact even at high temperature. Thus, a reliable electrical connection is formed. The temperatures, to which the spring element is exposed, may range up to 700 to 1500 degrees centigrade or higher.

The vacuum deposition system comprises a vacuum deposition source heating system with at least one such an elastic connection between the power supply and the heating element. Advantageously, however, two such connections are formed for a heating element, one for each terminal of the power supply. Advantageously, there are two or more heaters provided in a vacuum deposition source, in which case one or all power terminals of one or all heaters may each be contacted to a corresponding power supply element by an elastic connection comprising a spring element as described above and in the following.

The heating element may comprise a crucible, holding means for the crucible and conductive leads for transporting electrical power from the power supply element to the crucible. The connection member may in addition to the spring element comprise fixation elements such as screws, clamps, fasteners etc., for mechanically engaging the power supply element and building the electrical connection to the heating element. The connection member may also include the holder of the heating element itself.

The spring element of the connection member may have the shape of a rod or a plate. It may have a length dimension of at least 20, 30, 40, 50 mm or more. Preferably it has a length dimension of between 20 and 150 mm, advantageously between 40 and 120 mm. It may be made with elasticity such that it flexes by at least 1 to 3 mm over a length of 40 to 120 mm.

The spring element may be bent in order to exert an elastic force. For example, when the spring element has the shape of a rod or a rectangular plate, it may bend along an elongated dimension. Alternatively or cumulatively, the spring element may be compressed in order to exert the elastic force. In the latter case, the compression may happen along the smallest dimension, i.e. along the thickness of the spring element. In order to allow such compression, the spring element may for example be made of carbon foam or carbon felt.

In a preferred embodiment, the spring element is made of carbon fiber/CFC (carbon fiber reinforced carbon) and/or of pyrolytic carbon. Such pyrolytic carbon may for example be made by a vapor deposition process, such as chemical vapor deposition (CVD).

The spring element according to an advantageous embodiment is made of carbon foam or carbon felt. This may even be the case when the elastic force is exerted by the spring element due to bending and not due to compression of the spring element, as described above.

Vacuum deposition source heating system according to one of the previous claims, characterized by that the spring element contains at least 50%, 60%, 70%, 80%, or 90% carbon, or is substantially entirely made of carbon. The term "substantially" in this case means that the spring element is made entirely of carbon, barring any unintended impurities or impurities due to the fabrication process.

In some preferred embodiments, the power supply element is electrically connected to the heating element via the spring element. In such embodiment, the electrical current will flow through the spring member to reach the heater. However, in alternative embodiments, the current will not have to flow through the spring element.

The power supply element, which is electrically connected to the heating element by way of the connection member, is designed for providing electrical power to the heating element from a power source. The power supply element may be a conductive lead in the shape of a wire, a ribbon, a strip, a strap, a rod or of any other suitable shape. Furthermore, the power supply element may be either flexible or rigid or a combination of both, i.e. it may have a flexible section and a rigid section.

Advantageously, the power supply element has an elongated shape. In preferred embodiments, the power supply element has the shape of a rod with a flat, a rectangular, a square, an oval, or a circular cross section. The power supply element may preferably be made of carbon, in particular in form of graphite.

In an especially reliable embodiment, the power supply element is at least partly covered by an insulating cover of electrically insulating material. The insulating cover is, in a preferred embodiment, made of aluminum oxide, for example of dense aluminum oxide having a density of at least 3,50g/cm³ or higher. In particular, the part of the power supply element, which is mechanically connected to the heating element by way of the connection element, or which is mechanically connected to the connection element itself, may preferably be exposed, while the rest of the power supply element is covered by the insulating cover. The power supply element may itself be electrically connected to or part of a power supply member comprising electrical connections to a power source.

In the following, the invention is explained with reference to the figures on the basis of exemplary embodiments. Therein,
- Fig. 1: shows an exploded view on the connection between a heating element and a power supply element by way of a connection member according to one preferred embodiment, and
- Fig. 2: shows an exploded view on the connection between a heating element and a power supply element by way of a connection member according to another preferred embodiment.

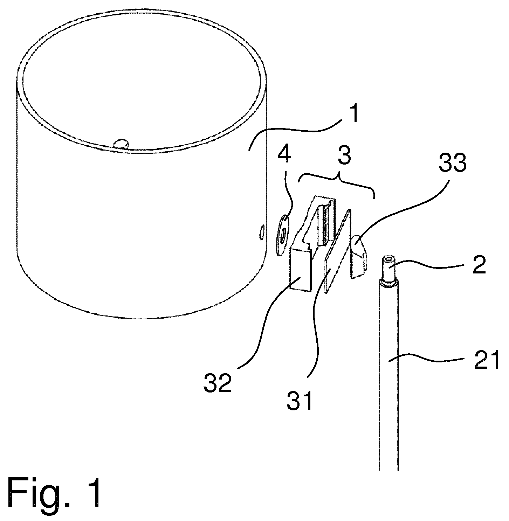

Fig. 1 shows an exploded view on the connection between a heating element 1 and a power supply element 2. The heating element 1 is shown to have the shape of a cylinder, in which different parts for heating a crucible filled with the source material or for otherwise heating the source material directly are placed.

The power supply element 2 carries electrical current for operating the heating element 1. The electrical as well as mechanical connection between the heating element 1 and the power supply element 2 is accomplished by a connection member 3 placed between them. In alternative embodiments, the connection member 3 may also be partly placed on the far side, with respect to the heating element 1, of the power supply element 2, e.g. the power supply element 2 may be partly or fully surrounded or enveloped by the connection member 3.

The connection member 3 in Fig. 1 comprises three parts, as described in the following. The central part of the connection member 3 is a spring element 31 made of an elastic carbon material which is responsible for the mechanic elasticity in the connection between the heating element 1 and the power supply element 2. Furthermore, the connection member 3 comprises a holding element 32 for the spring element 31, and an adapter 33 for attachment to the power supply element 2. The holding element 32 has the shape of a bracket, which supports the two distant edges of the plate shaped spring element 31 and allows the spring element 31 to bend in the middle region between these two distant edges. The holding element 32 itself is fixed to a conductive washer 4 attached to the heating element 1.

The adapter 33 is attached to the bending region of the spring element 31 and carries the power supply element 2. The adapter 33 is provided for distributing the pressure force of the power supply element 2 onto the spring element 31 more evenly. The power supply element 2 has itself the shape of a rod and is rigid. It is covered by an insulating cover 21 except for its tip, which is exposed to allow forming a contact with the adapter 33. The insulating cover 21 may be made of Aluminum-Oxide to withstand the heat and remain insulating.

In the setting shown in Fig. 1, the current flowing through the power supply element 2 flows also consecutively through the adapter 33, through the spring member 31 and through the bracket shaped holding element 32, before reaching the conductive washer 4 and ultimately the heating element 1. Instead of being in the path of the current, the spring element 31 may also be placed on the other side (the far side) of the power supply element 2 when viewed from the heating element 1. In that case, the spring element 1 is pushing onto the power supply element 2 and does not carry the current from it.

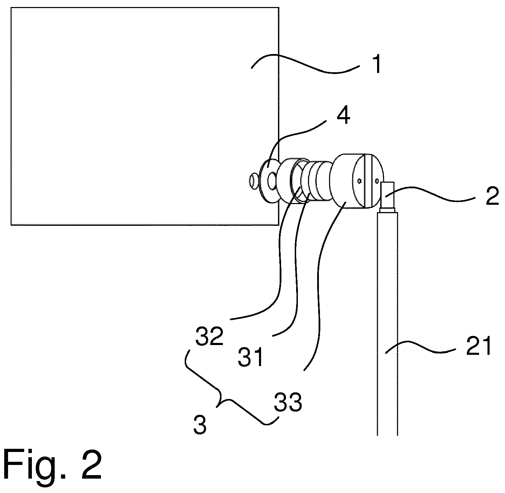

Fig. 2 shows in an exploded view a different embodiment of the connection member 3 for forming the electrical and mechanical contact between heating element 1 and the power supply element 2. Here, the spring element 31 has the form of a short cylinder or a pill. With this shape, the spring element 31 may be made of carbon foam or carbon felt in order to be compressible. Thus, the springiness or elasticity of the spring element 31 in this embodiment stems from its compressibility.

The holding element 32 and the adapter 33 in this embodiment come in the shape of a pill box enclosing the spring element 31. However, the spring element 31 is along its longitudinal axis high enough, such that there is a considerable compression length before the adapter 33 comes to rest onto the holding element 32. As with the embodiment according to Fig. 1, also here the current flowing from the power supply element 2 to the heating element 1 flows through the spring element 31.

### Reference Numeral:

- 1: heating element
- 2: power supply element
- 21: insulating cover

- 3: connection member
- 31: spring element
- 32: holding element (bracket)
- 33: adapter

- 4: conductive washer

## Claims

1. Vacuum deposition source heating system, mountable to a vacuum deposition system and comprising:
- a heating element (1) designed for heating a deposition source,
- a power supply element (2), electrically connected to the heating element for providing electrical power to the heating element (1);
- a connection member (3), electrically connecting the power supply element (2) to the heating element,
whereby the power supply element is mechanically mounted to the connection member (3) in an elastic manner, and whereby the connection member comprises a spring element (31) made of an elastic carbon material.

2. Vacuum deposition source heating system according to claim 1, **characterized by** that the spring element is made of carbon fiber/CFC (carbon fiber reinforced carbon) and/or of pyrolytic carbon.

3. Vacuum deposition source heating system according to claim 1 or 2, **characterized by** that the spring element is made of carbon foam or carbon felt.

4. Vacuum deposition source heating system according to one of the previous claims, **characterized by** that the spring element contains at least 50%, 60%, 70%, 80%, or 90% carbon, or is substantially entirely made of carbon.

5. Vacuum deposition source heating system according to one of the previous claims, **characterized by** that the power supply element (2) is electrically connected to the heating element (1) via the spring element.

6. Vacuum deposition source heating system according to one of the previous claims, **characterized by** that the power supply element (2) has an elongated shape.

7. Vacuum deposition source heating system according to claim 6, **characterized by** that the power supply element (2) has the shape of a rod with flat, a rectangular, a square, an oval, or a circular cross section.

8. Vacuum deposition source heating system according to one of the previous claims, **characterized by** that the power supply element (2) is made of carbon.

9. Vacuum deposition source heating system according to one of the previous claims, **characterized by** that the power supply element (2) is at least partly covered by an insulating cover (21) of electrically insulating material.

10. Vacuum deposition source heating system according to one of the previous claims, **characterized by** that the insulating cover (21) is made of aluminum oxide.

11. Vacuum deposition system comprising a vacuum deposition source heating system according to one of the previous claims.

## Patentansprüche

1. Heizsystem für Vakuumabscheidequelle, das an einer Vakuumabscheidevorrichtung anbringbar ist und umfasst:
- ein Heizelement (1), das zum Erhitzen einer Abscheidequelle ausgebildet ist,
- ein Stromversorgungselement (2), das zum Zuführen von elektrischem Strom zu dem Heizelement (1) elektrisch mit dem Heizelement verbunden ist,
- ein Verbindungsglied (3), welches das Stromversorgungselement (2) mit dem Heizelement elektrisch verbindet,
wobei das Stromversorgungselement auf elastische Weise an dem Verbindungsglied (3) mechanisch angebracht ist und wobei das Verbindungsglied ein Federelement (31) umfasst, das aus einem elastischen Kohlenstoffmaterial hergestellt ist.

2. Heizsystem für Vakuumabscheidequelle nach Anspruch 1, **dadurch gekennzeichnet, dass** das Federelement aus Kohlenstofffasern/CFC (kohlenstofffaserverstärktem Kohlenstoff) und/oder aus pyrolytischem Kohlenstoff hergestellt ist.

3. Heizsystem für Vakuumabscheidequelle nach Anspruch 1 oder 2, **dadurch gekennzeichnet, dass** das Federelement aus Kohlenstoffschaum oder Kohlenstofffilz hergestellt ist.

4. Heizsystem für Vakuumabscheidequelle nach einem der vorhergehenden Ansprüche, **dadurch gekennzeichnet, dass** das Federelement mindestens 50% 60% 70% 80%oder 90%Kohlenstoff enthält oder im Wesentlichen zur Gänze aus Kohlenstoff hergestellt ist.

5. Heizsystem für Vakuumabscheidequelle nach einem der vorhergehenden Ansprüche, **dadurch gekennzeichnet, dass** das Stromversorgungselement (2) über das Federelement mit dem Heizelement (1) elektrisch verbunden ist.

6. Heizsystem für Vakuumabscheidequelle nach einem der vorhergehenden Ansprüche, **dadurch gekennzeichnet, dass** das Stromversorgungselement(2) eine längliche Gestalt aufweist.

7. Heizsystem für Vakuumabscheidequelle nach Anspruch 6, **dadurch gekennzeichnet, dass** das Stromversorgungselement (2) die Form einer Stange mit einem flachen, einem rechteckigen, einem quadratischen, einem ovalen oder einem kreisförmigen Querschnitt aufweist.

8. Heizsystem für Vakuumabscheidequelle nach einem der vorhergehenden Ansprüche, **dadurch gekennzeichnet, dass** das Stromversorgungselement (2) aus Kohlenstoff hergestellt ist.

9. Heizsystem für Vakuumabscheidequelle nach einem der vorhergehenden Ansprüche, **dadurch gekennzeichnet, dass** das Stromversorgungselement (2) mindestens teilweise mit einer Isolationsabdeckung (21) aus elektrisch isolierendem Material ummantelt ist.

10. Heizsystem für Vakuumabscheidequelle nach einem der vorhergehenden Ansprüche, **dadurch gekennzeichnet, dass** die Isolationsabdeckung (21) aus Aluminiumoxid hergestellt ist.

11. Vakuumabscheidevorrichtung, die ein Heizsystem für eine Vakuumabscheidequelle nach einem der vorhergehenden Ansprüche umfasst.

## Revendications

1. Système de chauffage pour une source de dépôt sous vide pouvant être monté à un système de dépôt sous vide et comprenant:
- un élément chauffant (1) conçu pour chauffer une source de dépôt,
- un élément d'alimentation (2) connecté électriquement à l'élément chauffant pour fournir une puissance électrique à l'élément chauffant (1);
- un élément de raccordement (3) reliant électriquement l'élément d'alimentation (2) à l'élément chauffant,
dans lequel l'élément d'alimentation est monté mécaniquement à l'élément de raccordement (3) de manière élastique et dans lequel l'élément de raccordement comprend un élément de ressort (31) réalisé en un matériau élastique de carbone.

2. Système de chauffage pour une source de dépôt sous vide selon la revendication 1, **caractérisé en ce que** l'élément de ressort est réalisé en fibre de carbone / CFC (carbone renforcé en fibre de carbone) et / ou en carbone pyrolytique.

3. Système de chauffage pour une source de dépôt sous vide selon la revendication 1 ou 2, **caractérisé en ce que** l'élément de ressort est réalisé en mousse de carbone ou en feutre de carbone.

4. Système de chauffage pour une source de dépôt sous vide selon l'une des revendications précédentes, **caractérisé en ce que** l'élément de ressort contient au moins 50% 60% 70% 80% ou 90%de carbone, ou est réalisé essentiellement entièrement en carbone.

5. Système de chauffage pour une source de dépôt sous vide selon l'une quelconque des revendications précédentes, **caractérisé en ce que** l'élément d'alimentation (2) est connecté électriquement à l'élément chauffant (1) via l'élément de ressort.

6. Système de chauffage pour une source de dépôt sous vide selon l'une quelconque des revendications précédentes, **caractérisé en ce que** l'élément d'alimentation (2) a une forme allongée.

7. Système de chauffage pour une source de dépôt sous vide selon la revendication 6, **caractérisé en ce que** l'élément d'alimentation (2) a la forme d'une tige ayant une coupe transversale plate, rectangulaire, carrée, ovale ou circulaire.

8. Système de chauffage pour une source de dépôt sous vide selon l'une quelconque des revendications précédentes, **caractérisé en ce que** l'élément d'alimentation (2) est réalisé en carbone.

9. Système de chauffage pour une source de dépôt sous vide selon l'une quelconque des revendications précédentes, **caractérisé en ce que** l'élément d'alimentation (2) est au moins partiellement couvert par une couverture isolante (21) en matériau électriquement isolant.

10. Système de chauffage pour une source de dépôt sous vide selon l'une quelconque des revendications précédentes, **caractérisé en ce que** la couverture isolante (21) est réalisée en oxyde d'aluminium.

11. Système de dépôt sous vide comprenant un système de chauffage pour une source de dépôt sous vide selon l'une quelconque des revendications précédentes.
